# EUROPEAN PATENT SPECIFICATION

(11) **EP 3 302 012 B1**
(45) Date of publication and mention of the grant of the patent: **09.09.2020**
(21) Application number: 17161193.2
(22) Date of filing: 15.03.2017
(51) Int. Cl.: H05K 7/14

(54) **RACKMOUNT CHASSIS**
RACKMOUNT-CHASSIS
CHÂSSIS MONTÉ SUR BÂTI

(30) Priority: 02.10.2016 IL 24816616
(43) Date of publication of application: 04.04.2018
(73) Proprietor: TDK-LAMBDA LTD, 2161401 Karmiel Industrial Zone (IL)
(72) Inventor: RUCAREANU, George, 3681001 NESHER (IL); STRAVETS, Miki, 2623196 KIRYAT MOTZKIN (IL)
(74) Representative: Branca, Emanuela

(56) References cited:
- US-A- 5 129 594
- US-A- 5 195 644
- US-A1- 2004 190 246
- US-A1- 2008 304 228
- US-A1- 2015 216 061

## Description

### Field of the Invention

The present invention relates to the field of rack mounted devices. More particularly, the invention relates to a chassis providing beneficial mechanical characteristics for such devices.

### Background of the Invention

A rack is a type of frame that facilitates the stacking of electronic devices one on top of the other. For many industrial applications, a rack typically, but not necessarily, having a width of 19 inches is used for the compact stacking of each rectangular chassis that houses an electronic device, for example a power supply, memory device or network communication device.

The chassis is traditionally made of steel as a result of its structural strength, widespread availability and relatively low cost. Since steel tends to corrode when exposed to moisture in the surrounding air, a thin zinc coating is applied to protect the steel from corrosion. However, zinc whiskers characterized by tiny hair-like filaments are known to grow from zinc-coated metal surfaces, and some experts maintain that their growth is encouraged by exposure to compressive mechanical stresses. The presence of whiskers can be very damaging to the electronic devices housed in the chassis when they break off and cause short circuits or act as miniature antennas to affect circuit impedance in fast digital circuits.

Other disadvantages associated with the use of a steel rackmount chassis include its relatively heavy weight and high permeability that freely permits the radiated emission associated with the magnetic field generated by the circuits of the electronic device housed within the chassis to travel through the material. If the magnitude of the magnetic field is sufficiently large, it has the potential to destroy other sensitive electronic equipment.

A chassis made of sheet metal and provided with a cover is disclosed in US 2004/0190246.

It is an object of the present invention to provide a rackmount chassis made of a structurally strong material of low weight.

It is an additional object of the present invention to provide a rackmount chassis made of a material having low magnetic field permeability.

It is an additional object of the present invention to provide a rackmount chassis made of a material that is not prone to whisker formation.

Other objects and advantages of the invention will become apparent as the description proceeds.

### Summary of the Invention

The present invention provides a rectilinear rackmount chassis, comprising a three-dimensional base piece fabricated from a single piece of sheet metal which is made of aluminum 6061 T651, and a cover piece fitted over, and mating with, said base piece.

The structural strength of aluminum 6061-T651 is particularly suited for preventing buckling of a rackmount chassis having a large width of 19 inches, or more, yet such a rackmount chassis is significantly lighter than its steel counterpart.

In one aspect, the base piece is configured with a central portion, a front panel portion, a rear panel portion, and two opposed side portions, said front panel portion, rear panel portion, and two opposed side portions being bendable with respect to said central portion to facilitate a fixed connection between each of said two side portions and said front and rear panel portions. The fixed connection may be a tab which is bent and welded.

The cover piece may also be made of aluminum 6061-T651.

### Brief Description of the Drawings

In the drawings:
- Fig. 1 is a perspective view from the top of a rackmount chassis, according to one embodiment of the invention;
- Fig. 2 is a top or bottom view of a base piece for use in conjunction with the chassis of Fig. 1, shown in an unbent condition;
- Fig. 3 is a perspective view from the top of the base piece of Fig. 2, shown in a fabricated condition; and
- Fig. 4 is an enlargement of Detail A of Fig. 3.

### Detailed Description of Preferred Embodiments

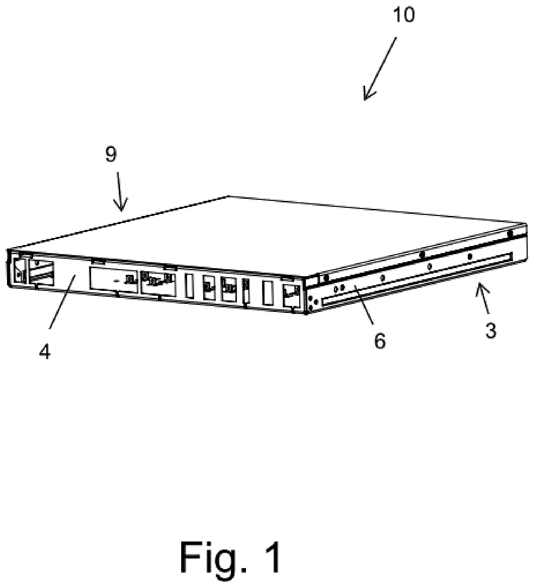

Fig. 1 illustrates rackmount chassis 10, according to one embodiment of the invention, which is made entirely of aluminum. The aluminum chassis is significantly lighter than a prior art carbon steel rackmount chassis to reduce transportation costs, yet is structurally strong. Since aluminum is corrosion resistant, chassis 10 does not have to be coated, and is therefore not prone to whisker formation. Rectilinear chassis 10 preferably has a width of 19 inches, although other widths are also in the scope of the invention.

Chassis 10 may advantageously be made of two pieces of aluminum sheet material: a first lower base piece 3 that encloses the circuitry of the electronic device and a second cover piece 9 fitted over, and mating with, base piece 3. Base piece 3 has sufficiently bendability to allow a first portion 4 thereof, for example a front panel, to be connected to a second portion 6 thereof, for example a side surface. An exemplary aluminum sheet material thickness is 1.2 mm and an exemplary internal bend radius is 1.2 mm.

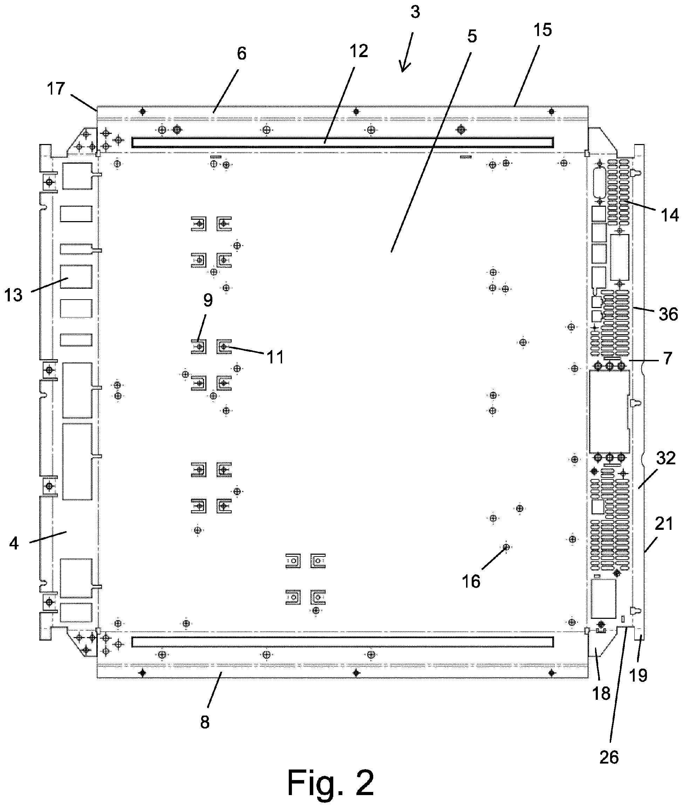

The sheet metal of base piece 3 is shown in an unbent condition in Fig. 2. Central bottom portion 5 is interposed between front panel portion 4 and rear panel portion 7, and is also interposed between side portions 6 and 8, which are at right angles to front panel portion 4 and rear panel portion 7. Panel portions 4 and 7 are formed with a plurality of cutouts 13 to accommodate the placement of input or display elements associated with the circuitry of the housed electronic device. Rear panel portion 7 is also formed with a plurality of cutouts 14 to define air openings. Regions 9 of bottom portion 5 are punched out to define corresponding rectangular, integral flexible contacts 11, and other regions are punched out to define mounting holes 16.

Side portions 6 and 8 are each delimited by an upper edge 15 and by two opposed side edges 17 that are perpendicular to the corresponding upper edge 15. An embossed region 12, e.g. rectangular, is formed in each side portion to increase the rigidity of base piece 3 when fabricated.

Each side edge 17 of a side portion is contiguous with, and protrudes from, a triangular tab 18 of the adjacent panel portion. Each panel portion is also configured with a rectangular tab 19 that is contiguous with edge 21 of the corresponding panel portion. Rectangular tab 19 is shorter than triangular tab 18, as measured from a side edge 26 of the panel portion.

The relative positional terms such as "upper", "bottom", "side", "front" and "rear" are presented relative to the disposition of base piece 3 of the chassis when bent to a three-dimensional configuration in order to house the electronic device.

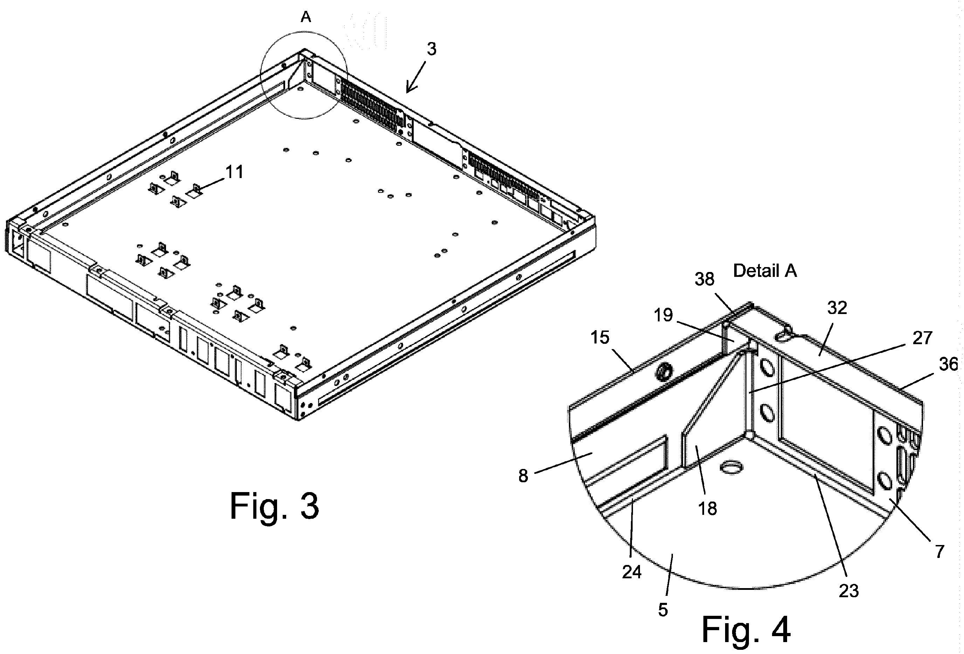

Fig. 3 illustrates base piece 3 when set to a three-dimensional fabricated condition, such that each side portion is connected to both panel portions. The flexible contacts 11 are shown to be in a bent condition, for connection to an electronic component.

In order to fabricate the three-dimensional base piece 3, as shown in Fig. 4, the illustrated rear panel portion 7 and side portion 8 are bent about bottom portion 5 to define horizontal bend lines 23 and 24, respectively. Similarly, front panel portion 4 and side portion 6 are bent about bottom portion 5. In order to achieve the fabricated condition, triangular tab 18 is bent about rear panel portion 7 to define vertical bend line 27, and is welded to side portion 8. Additionally, rear panel portion 7 is bent about a horizontal bend line 36, which is schematically represented by dashed lines in Fig. 2 and extends between the lower edge of the two opposed rectangular tabs 19, to define a horizontal lip 32, which may support the cover piece. Lip 32 may have a bend precision of 10 mm, corresponding to the distance between bend line 36 and edge 21, over a length of 500 mm. The illustrated rectangular tab 19 is then bent about lip 32 to form a bend line 38 that is substantially coincident with upper edge 15 of side portion 8. The resulting vertically disposed rectangular tab 19 is welded to side portion 8 to achieve a surprisingly strong base piece made of a single piece of sheet metal.

This arrangement of bending lip 32 about horizontal bend line 36 and then tabs 18 and 19 about a vertical bend line increases the mechanical strength of base piece 3 as a U-shaped profile characterized by a relatively large moment of inertia is produced in both the lengthwise direction between front panel 44 and rear panel 47 and in the sidewise direction between sides 46 and 48.

The bend radius at each of bend lines 23, 24 and 38 may be 1.2 mm, although any other suitable radius is also feasible.

It has now been found that a suitable material for rackmount chassis 10 is aluminum 6061 T651. This material has been used for airplane fuselage, automotive parts and yacht construction, but heretofore has been unknown to be used for a rackmount chassis.

Aluminum 6061 is an aluminum alloy having magnesium and silicon as its alloying elements, and has good corrosion resistance, machinability and weldability.

The T651 temper is carried out by stretching a plate of alloy 6061 following a heat treatment and prior to an artificial aging treatment. The stretching operation serves to flatten the plate and to relive the high level of stresses induced into the plate as a result of being quenched in water coolant after the heat treatment. Water quenching normally causes plate distortion and uneven flatness. A plate of alloy 6061 is thus afforded post-machining stability such that it resists distortion and buckling.

Other tempers of aluminum alloy 6061 such as T6 are not subjected to the stretching operation- for example they undergo a roller leveling technique in order to achieve an acceptable flatness; however, this technique does not relieve the quenching stresses.

Tables I and II compare the performance of the T651 temper to different tempers of aluminum 6061 with respect to various parameters of importance.

**Table I**

| **T651 vs T451** | | |
|---|---|---|
| | **T651** | **T451** |
| **Tensile Strength (MPa)** | 310 | 241 |
| **Yield Strength (MPa)** | 276 | 145 |
| **Shear Strength (MPa)** | 207 | 165 |
| **Density (g/cm³)** | 2.70 | 2.70 |
| **Elastic Modulus (GPa)** | 68.9 | 68.9 |
| **Elongation, thickness-1.6mm (%)** | 12 | 22 |
| **Elongation, diameter-13mm (%)** | 17 | 25 |
| **Machinability Rating (%)** | 50 | 50 |
| **Electrical Resistivity (ohm-cm)** | 0.00000399 | 0.00000432 |

**Table II**

| **T651 vs T0** | | |
|---|---|---|
| | **T651** | **T0** |
| **Tensile Strength (MPa)** | 310 | 124 |
| **Yield Strength (MPa)** | 276 | 55 |
| **Shear Strength (MPa)** | 207 | 83 |
| **Density (g/cm³)** | 2.70 | 2.70 |
| **Elastic Modulus (GPa)** | 68.9 | 68.9 |
| **Elongation, thickness-1.6mm (%)** | 12 | 25 |
| **Elongation, diameter-13mm (%)** | 17 | 30 |
| **Machinability Rating (%)** | 50 | 30 |
| **Electrical Resistivity (ohm-cm)** | 0.00000399 | 0.00000366 |

Table III compares aluminum 6061-T651 with aluminum 5052-H32.

**Table III**

| **T651 vs 5052-H32** | | |
|---|---|---|
| | **T651** | **5052-H32** |
| **Tensile Strength (MPa)** | 310 | 228 |
| **Yield Strength (MPa)** | 276 | 193 |
| **Shear Strength (MPa)** | 207 | 138 |
| **Density (g/cm³)** | 2.70 | 2.68 |
| **Elastic Modulus (GPa)** | 68.9 | 70.3 |
| **Elongation, thickness-1.6mm (%)** | 12 | 12 |
| **Elongation, diameter-13mm (%)** | 17 | 18 |
| **Electrical Resistivity (ohm-cm)** | 0.00000399 | 0.00000499 |

Table IV compares aluminum 6061-T651 with cold rolled AISI 1020 steel.

**Table IV**

| **T651 vs AISI 1020** | | |
|---|---|---|
| | **T651** | **AISI 1020** |
| **Tensile Strength (MPa)** | 310 | 420 |
| **Yield Strength (MPa)** | 276 | 350 |
| **Density (g/cm³)** | 2.70 | 7.87 |
| **Elastic Modulus (GPa)** | 68.9 | 186 |
| **Elongation, thickness-1.6mm (%)** | 12 | 15 |
| **Machinability Rating (%)** | 50 | 65 |

As can be seen, the yield strength of aluminum 6061-T651 is 78.9% that of AISI 1020 steel even though its density is only 34.3% of AISI 1020 steel. The structural strength of aluminum 6061-T651 is particularly suited for preventing buckling of a rackmount chassis having a large width of 19 inches, or more, yet such a rackmount chassis is significantly lighter than its steel counterpart.

Other advantages of aluminum 6061-T651 include its low magnetic field permeability, its resistance to whisker formation and its relatively low electrical resistivity to promote good ground connections for the return path of current from the electronic devices housed within the chassis. Also, it has good corrosion resistance, machinability and weldability.

While some embodiments of the invention have been described by way of illustration, it will be apparent that the invention can be carried out with many modifications, variations and adaptations, and with the use of numerous equivalents or alternative solutions that are within the scope of the invention which is defined by the appended claims.

## Claims

1. A rectilinear rackmount chassis (10), comprising a three-dimensional base piece (3) fabricated from sheet metal, and a cover piece (9) fitted over, and mating with, said base piece (3) **characterized in that** the base piece is fabricated from a single piece of sheet metal which is made of aluminum 6061 T651.

2. The rackmount chassis (10) according to claim 1, wherein the cover piece (9) is also made of aluminum 6061 T651.

3. The rackmount chassis (10) according to claim 1, wherein the base piece (3) is configured with a central portion (5), a front panel portion (4), a rear panel portion (7), and two opposed side portions (6, 8), said front panel portion (4), rear panel portion (7), and two opposed side portions (6, 8) being bendable with respect to said central portion (5) to facilitate a fixed connection between each of said two side portions (6, 8) and said front and rear panel portions (4, 7).

4. The rackmount chassis (10) according to claim 3, wherein the fixed connection is a tab (18, 19) which is bent and welded.

5. The rackmount chassis (10) according to claim 1, which has a width of 19 inches.

## Patentansprüche

1. Geradliniges Rackmount-Chassis (10), umfassend ein aus Blech angefertigtes dreidimensionales Bodenteil (3) und ein darauf aufgesetztes, passendes Abdeckteil (9), wobei das Bodenteil (3) **dadurch gekennzeichnet ist, dass** das Bodenteil aus einem einzelnen, aus Aluminium 6061 T651 hergestellten Stück Blech angefertigt ist.

2. Rackmount-Chassis (10) nach Anspruch 1, wobei das Abdeckteil (9) ebenfalls aus Aluminium 6061 T651 hergestellt ist.

3. Rackmount-Chassis (10) nach Anspruch 1, wobei das Bodenteil (3) mit einem mittleren Abschnitt (5), einem Vorderwandabschnitt (4), einem Rückwandabschnitt (7) und zwei gegenüberliegenden Seitenabschnitten (6, 8) ausgebildet ist, wobei der Vorderwandabschnitt (4), der Rückwandabschnitt (7) und die zwei gegenüberliegenden Seitenabschnitte (6, 8) in Bezug auf den mittleren Abschnitt (5) biegbar sind, um eine feste Verbindung zwischen jedem der zwei Seitenabschnitte (6, 8) und den Vorder- und Rückwandabschnitten (4, 7) zu erleichtern.

4. Rackmount-Chassis (10) nach Anspruch 3, wobei die feste Verbindung eine Lasche (18, 19) ist, die biegbar und geschweißt ist.

5. Rackmount-Chassis (10) nach Anspruch 1, das eine Breite von 19 Zoll aufweist.

## Revendications

1. Un châssis monté sur bâti rectiligne (10), comprenant une pièce de base tridimensionnelle (3) fabriquée à partir de tôle, et une pièce de couverture (9) emboîtée sur, et s'accouplant avec, ladite pièce de base (3) **caractérisée en ce que** la pièce de base est fabriquée à partir d'une seule pièce de tôle qui est constituée d'aluminium 6061 T651.

2. Le châssis monté sur bâti (10) selon la revendication 1, dans lequel la pièce de couverture (9) est également constituée d'aluminium 6061 T651.

3. Le châssis monté sur bâti (10) selon la revendication 1, dans lequel la pièce de base (3) est configurée avec une partie centrale (5), une partie de panneau avant (4), une partie de panneau arrière (7), et deux parties latérales opposées (6, 8), ladite partie de panneau avant (4), la partie de panneau arrière (7), et les deux parties latérales opposées (6, 8) étant pliables par rapport à ladite partie centrale (5) pour faciliter un raccordement fixe entre chacune desdites deux parties latérales (6, 8) et lesdites parties de panneau avant et arrière (4, 7).

4. Le châssis monté sur bâti (10) selon la revendication 3, dans lequel le raccordement fixe est une languette (18, 19) qui est pliée et soudée.

5. Le châssis monté sur bâti (10) selon la revendication 1, qui a une largeur de 19 pouces.
